# EUROPEAN PATENT SPECIFICATION

(11) **EP 0 961 407 B1**
(45) Date of publication and mention of the grant of the patent: **06.08.2003**
(21) Application number: 99304000.5
(22) Date of filing: 24.05.1999
(51) Int. Cl.: H03J 5/24

(54) **Television tuner**
Fernsehempfänger
Circuit d'accord de télévision

(30) Priority: 26.05.1998 JP 14437498
(43) Date of publication of application: 01.12.1999
(73) Proprietor: ALPS ELECTRIC CO., LTD., Ota-ku Tokyo 145 (JP)
(72) Inventor: Yamamoto, Masaki, Futaba-gun, Fukushima-ken (JP); Sasaki, Michinori, Sannohe-gun, Amomori-ken (JP)
(74) Representative: Kensett, John Hinton

(56) References cited:
- EP-A- 0 065 150
- EP-A- 0 472 319
- WO-A-87/04304
- FR-A- 2 559 634
- US-A- 4 361 909

## Description

The present invention relates to a shared television tuner capable of receiving both of respective television broadcasts (hereinafter abbreviated as "TV broadcasts") of the PAL-B/G and SECAM-L systems, and particularly to a television tuner capable of preventing degradation in receiving performance, which takes place due to the differences in intermediate frequency between the respective systems and between broadcast frequency bands.

A television tuner according to the preamble of claim 1 is known e.g. from EP-A-0 065 150.

As TV broadcast systems which have been adopted in Europe, there are known the PAL-B/G system adopted in Germany, etc. and the SECAM-L system adopted in France, etc. A shared television tuner capable of receiving TV broadcasts of these two systems has already been developed.

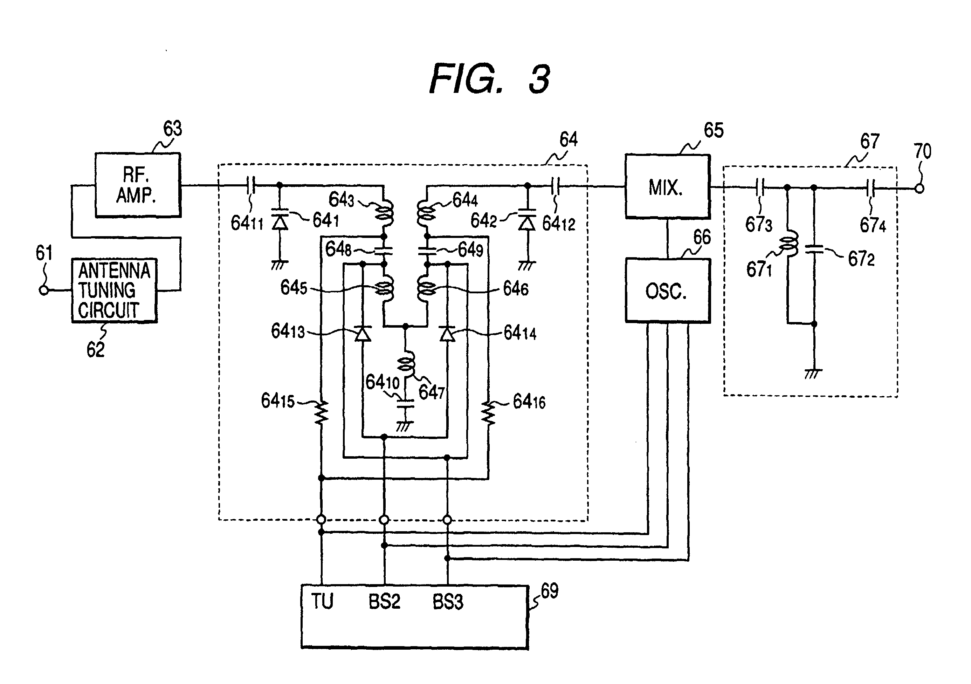

Fig. 3 is a block diagram partly including a circuit diagram, showing one example of a configuration of the already-known shared television tuner.

As shown in Fig. 3, the already-known television tuner comprises an input terminal 61, an antenna (ANT) tuning circuit 62, a high-frequency amplifier circuit (RFAMP) 63, a high-frequency double tuned circuit 64, a mixer (MIX) 65, a local oscillator (OSC) 66, an intermediate frequency tuning circuit 67, a channel selection IC 69, and an output terminal 70.

The high-frequency double tuned circuit 64 has an input terminal electrically connected to an output terminal of the high-frequency amplifier circuit 63 and an output terminal electrically connected to a first input terminal of the mixer 65. Further, the high-frequency double tuned circuit 64 comprises variable capacitance diodes 64₁ and 64₂, inductors 64₃ through 64₇, capacitors 64₈ through 64₁₂, switching diodes 64₁₃ and 64₁₄, and resistors 64₁₅ and 64₁₆. Further, the local oscillator 66 has an output terminal electrically connected to a second input terminal of the mixer 65.

The intermediate frequency tuning circuit 67 has an input terminal electrically connected to an output terminal of the mixer 65 and an output terminal electrically connected to the output terminal 70. Further, the intermediate frequency tuning circuit 67 comprises an inductor 67₁ and capacitors 67₂ through 67₄.

The IC 69 is provided with a band decoder in addition to a PLL circuit and has a tuning voltage terminal TU, and band switching terminals BS2 and BS3. These respective terminals are respectively electrically connected to the high-frequency double tuned circuit 64 and the local oscillator 66. Incidentally, the tuning voltage terminal outputs a tuning voltage therethrough, the band switching terminal BS2 outputs a positive voltage therethrough when a TV broadcast lying in a VHF high-band is selected, and the band switching terminal BS3 outputs a positive voltage therethrough when a TV broadcast lying in a VHF low-band is selected.

The already-known shared television tuner constructed as described above is activated as follows:

A received signal applied to the input terminal 61 is inputted to the antenna tuning circuit 62 where a received signal corresponding to a desired channel is selected and thereafter amplified by the high-frequency amplifier circuit 63. The amplified received signal is inputted to the high-frequency double tuned circuit 64 where a received signal corresponding to a desired channel is further selected. The mixer 65 mixes the selected received signal and a local oscillation signal supplied from the local oscillator 66 so as to be converted into an intermediate frequency signal. The intermediate frequency signal is inputted to the intermediate frequency tuning circuit 67 where an intermediate frequency signal having a predetermined frequency is selected and outputted from the output terminal 70.

When a TV broadcast lying in a VHF low-band is now selected, a positive voltage is outputted from the band switching terminal BS3 of the IC 69. Thus, the high-frequency double tuned circuit 64 takes such a configuration that in response to the positive voltage, the switching diodes 64₁₃ and 64₁₄ are respectively turned off and hence the inductors 64₅ through 64₇ and the capacitor 64₁₀ are inserted into and connected to the variable capacitance diodes 64₁ and 64₂, the inductors 64₃ and 64₄, and the capacitors 64₈ and 64₉.

On the other hand, when a TV broadcast lying in a VHF high-band is selected, a positive voltage is outputted from the band switching terminal BS2 of the IC 69. Thus, the high-frequency double tuned circuit 64 takes such a configuration that in response to the positive voltage, the switching diodes 64₁₃ and 64₁₄ are respectively turned on so that a circuit portion comprised of the inductors 64₅ through 64₇ and the capacitor 64₁₀ is short-circuited and hence only the variable capacitance diodes 64₁ and 64₂, the inductors 64₃ and 64₄ and the capacitors 64₈ and 64₉ are electrically connected to one another.

Even when the TV broadcast lying in any band is selected, a tuning voltage is outputted from the tuning voltage terminal TU of the IC 69, so that the high-frequency double tuned circuit 64 is activated as follows. That is, since the tuning voltage is applied to the variable capacitance diode 64₁ through the resistor 64₁₅ and the inductor 64₃ and further applied to the variable capacitance diode 64₂ through the resistor 64₁₆ and the inductor 64₄, the respective capacitance of the variable capacitance diodes 64₁ and 64₂ are adjusted so as to be tuned to the selected TV broadcast.

In a manner similar to the high-frequency double tuned circuit 64, the local oscillator 66 is supplied with the positive voltage outputted from the band switching terminal BS3 or BS2 of the IC 69 and the tuning voltage outputted from the tuning voltage terminal TU thereof to thereby output a local oscillation signal having a frequency higher than that of the selected TV broadcast by a predetermined difference.

Meanwhile, the frequencies of a video or picture carrier and a voice or speech carrier of a TV broadcast of the SECAM (L) system lying in a VHF low-band are arranged in a high/low inverse relationship as compared with a TV broadcast of the PAL (B/G) system. Further, a frequency bandwidth per channel is widened by 1MHz.

Therefore, when the TV broadcast of the PAL (B/G) system is selected, a video or picture intermediate frequency, a chrominance intermediate frequency and a voice or speech intermediate frequency are respectively set to 38.9MHz, 34.47MHz and 33.4MHz which are standard. On the other hand, when the TV broadcast of the SECAM (L) system lying in the VHF low-band is selected, they are respectively set to 33.9MHz, 38.33MHz and 40.4MHz in consideration of the above-described difference and the characteristic of an intermediate frequency filter (not shown) formed by a surface acoustic wave device or element.

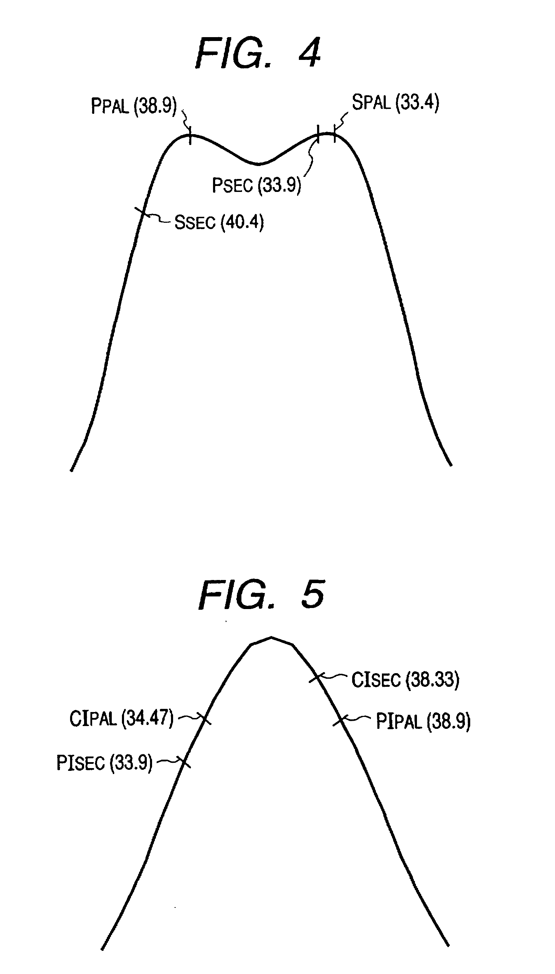

Fig. 4 shows tuning characteristics of the high-frequency double tuned circuit 64 of the already-known shared television tuner at the time that the TV broadcast lying in the VHF low-band is selected. Symbols P_{PAL} and S_{PAL} in the drawing indicate a video or picture carrier and a voice or speech carrier of the TV broadcast of the PAL (B/G) system, respectively, whereas symbols P_{SEC} and S_{SEC} indicate a picture carrier and a speech carrier of the TV broadcast of the SECAM (L) system, respectively. However, numeric values in the drawing are those represented by replacing the frequencies of the respective carriers with intermediate frequencies for convenience. The relationship in magnitude between the frequencies of the respective carriers is contrary to an arrangement of the numeric values in the drawing, i.e., they are small on the left side in Fig. 4, whereas they are large on the right side in Fig. 4.

As shown in Fig. 4, the tuning characteristic of the high-frequency double tuned circuit 64 is set so as to coincide with the TV broadcast of the PAL (B/G) system. In the tuning characteristic thereof, the tuning frequency of the high-frequency double tuned circuit 64 is made high by 1MHz with respect to each carrier of the TV broadcast of the SECAM (L) system lying in the VHF low-band, and the speech carrier S_{SEC} lies outside the band of the tuning characteristic.

Fig. 5 shows tuning characteristics of the intermediate frequency tuning circuit 67 of the already-known shared television tuner at the time that the TV broadcast lying in the VHF low-band is selected. Symbols PI_{PAL} and CI_{PAL} in the drawing indicate a video or picture intermediate frequency and a chrominance intermediate frequency of the TV broadcast of the PAL (B/G) system, respectively, whereas symbols PI_{SEC} and CI_{SEC} indicate a video or picture intermediate frequency and a chrominance intermediate frequency of the TV broadcast of the SECAM (L) system, respectively.

As shown in Fig. 5, the tuning characteristic of the intermediate frequency tuning circuit 67 is a single peak response, which is tuned to about 36.7MHz lying between a chrominance intermediate frequency CI_{PAL} of 34.47MHz and a picture intermediate frequency PI_{PAL} of 38.9MHz of the PAL (B/G) system. Thus, both selectivity to the picture intermediate frequency and the chrominance intermediate frequency are set so as to be substantially equal to each other. However, the tuning frequency is biased to a higher frequency rather than an intermediate frequency between a chrominance intermediate frequency CI_{SEC} of 38.33MHz of the SECAM (L) system lying in the VHF low-band and a picture intermediate frequency PI_{SEC} of 33.9MHz thereof with respect to the chrominance intermediate frequency CI_{SEC} of 38.33MHz and the picture intermediate frequency PI_{SEC} of 33.9MHz.

When the TV broadcast of the SECAM (L) system lying in the VHF low-band is selected as described above, the speech carrier S_{SEC} lies outside the band of the tuning characteristic of the high-frequency double tuned circuit 64. Therefore, a first problem arises in that the speech carrier is attenuated in the high-frequency double tuned circuit 64 so that a reproduced voice is low in level as compared with the selection of the TV broadcast lying in another band, whereby the voice is disagreeable to hear. Further, the tuning frequency of the intermediate frequency tuning circuit 67 is biased to the chrominance intermediate frequency CI_{SEC}. Therefore, a second problem arises in that the selectivity of the intermediate frequency tuning circuit 67 is high with respect to the chrominance intermediate frequency CI_{SEC} rather than the picture intermediate frequency PI_{SEC}, and a reproduced image becomes deep in color as compared with the selection of a TV broadcast lying in another band, whereby a satisfactory image or picture cannot be obtained.

As a method of solving the first problem, a first solving method is considered in which when the TV broadcast of the SECAM (L) system lying in the VHF low-band is selected, the tuning voltage outputted from the IC 69 is slightly reduced and the tuning frequency of the high-frequency double tuned circuit 64 is lowered by 1MHz. As a method of solving the second problem, a second solving method is considered wherein when the TV broadcast of the SECAM (L) system lying in the VHF low-band is selected, the tuning voltage outputted from the IC 69 is slightly increased to increase the oscillation frequency of the local oscillator 66, whereby the respective intermediate frequencies are increased by 0.6MHz.

However, since the high-frequency double tuned circuit 64 and the local oscillator 66 are controlled by the same tuning voltage, the respective methods referred to above cannot solve the two problems together.

With the foregoing problems in view, it is therefore an object of the present invention to provide a television tuner capable of reproducing both voices and an image in a satisfactory state even when either of TV broadcasts of the PAL (B/G) or SECAM (L) systems is received.

The invention is defined as set out in appended claim 1.

According to the present invention, for achieving the above object, there is provided a television tuner, comprising: a high-frequency double tuned circuit; an intermediate frequency tuning circuit; and means which is capable of receiving respective television broadcasts of PAL-B/L and SECAM L systems, and which sets respective tuning frequencies of the high-frequency double tuned circuit and the intermediate frequency tuning circuit so as to be adapted to the television broadcast of the PAL-B/G system, and lowers the respective tuning frequencies of the high-frequency double tuned circuit and the intermediate frequency tuning circuit when the television broadcast of the SECAM-L system lying in a VHF low-band is received.

According to the means referred to above, the tuning frequencies of the respective tuning circuits become low when the TV broadcast of the SECAM-L system lying in the VHF low-band is received, so that they result in tuning frequencies corresponding to the TV broadcast of the SECAM-L system lying in the VHF low-band. When another TV broadcast is received, the tuning frequencies become high, thus resulting in tuning frequencies corresponding to the TV broadcast of the PAL-B/G system and a TV broadcast of the SECAM-L system lying in a band other than the VHF low-band. Thus, even when either of the TV broadcasts is received, both selectivity of the high-frequency double tuned circuit to a picture carrier and a speech carrier can be made substantially equal to each other and both selectivity of the intermediate frequency tuning circuit to a picture intermediate frequency and a chrominance intermediate frequency can be substantially equalized.

In one of embodiments according to the present invention, means for lowering a tuning frequency of a high-frequency double tuned circuit is constructed such that the high-frequency double tuned circuit is provided with variable capacitance diodes and added bias voltages are respectively applied to the variable capacitance diodes together with a tuning voltage, thereby increasing the respective capacitance of the variable capacitance diodes as compared with the application of the tuning voltage alone. Means for lowering a tuning frequency of an intermediate frequency tuning circuit is constructed such that the intermediate frequency tuning circuit is provided with a variable capacitance diode and an added bias voltage is applied to the variable capacitance diode together with a fixed bias voltage, thereby increasing the capacitance of the variable capacitance diode as compared with the application of the fixed bias voltage alone.

In one preferred example showing the embodiment according to the present invention, added bias voltages are fractional voltages obtained by dividing a band switching voltage outputted from a channel selecting IC provided with a band decoder by resistance circuits. A fixed bias voltage is a voltage higher than the added bias voltages. A tuning voltage is applied to the cathodes of each individual variable capacitance diodes of a high-frequency double tuned circuit and the added bias voltages are respectively applied to the anodes thereof, whereas the fixed bias voltage is applied to the cathode of a variable capacitance diode of an intermediate frequency tuning circuit and an added bias voltage is applied to the anode thereof.

In another one of the embodiments according to the present invention, means for lowering a tuning frequency of a high-frequency double tuned circuit is constructed such that the high-frequency double tuned circuit is provided with variable capacitance diodes and added bias voltages are applied to the variable capacitance diodes together with a tuning voltage, thereby increasing the respective capacitance of the variable capacitance diodes as compared with the application of the tuning voltage alone. Further, means for lowering a tuning frequency of an intermediate frequency tuning circuit is constructed such that the intermediate frequency tuning circuit is provided with a fixed capacitor and an added capacitor series-connected to a switching diode, and a switching voltage is applied to the switching diode so as to bring the switching diode to an on state, thereby connecting the added capacitor in parallel with the fixed capacitor.

In another preferred example showing the embodiment of the present invention, added bias voltages are fractional voltages obtained by dividing a band switching voltage outputted from a channel selecting IC provided with a band decoder by resistance circuits. Further, a switching voltage is the band switching voltage. A tuning voltage is applied to the cathodes of variable capacitance diodes and the added bias voltages are respectively applied to the anodes thereof, whereas a fixed bias voltage lower than the band switching voltage is applied to the cathode of a switching diode and the band switching voltage is applied to the anode thereof.

Typical aspects of the present invention have been shown in brief. However, the various embodiments of the present invention and specific configurations thereof will be understood from the following description.

Embodiments of the invention will now be described, by way of example only, with reference to the accompanying drawings, in which:
Figs. 1 is a block diagram partly including a circuit diagram, showing a configuration of a first embodiment of a television tuner according to the present invention;
Fig. 2 is a block diagram partly including a circuit diagram, illustrating a configuration of a second embodiment of a television tuner according to the present invention;
Fig. 3 is a block diagram partly including a circuit diagram, showing a configuration of a conventional television tuner;
Fig. 4 is a tuning characteristic diagram of a high-frequency double tuned circuit employed in the conventional television tuner;
Fig. 5 is a tuning characteristic diagram of an intermediate frequency tuning circuit employed in the conventional television tuner;
Fig. 6 is a tuning characteristic diagram of a high-frequency double tuned circuit employed in each of the television tuners according to the first and second embodiments; and
Fig. 7 is a tuning characteristic diagram of an intermediate frequency tuning circuit employed in each of the television tuners according to the first and second embodiments.

Preferred embodiments of the present invention will hereinafter be described in detail with reference to the accompanying drawings.

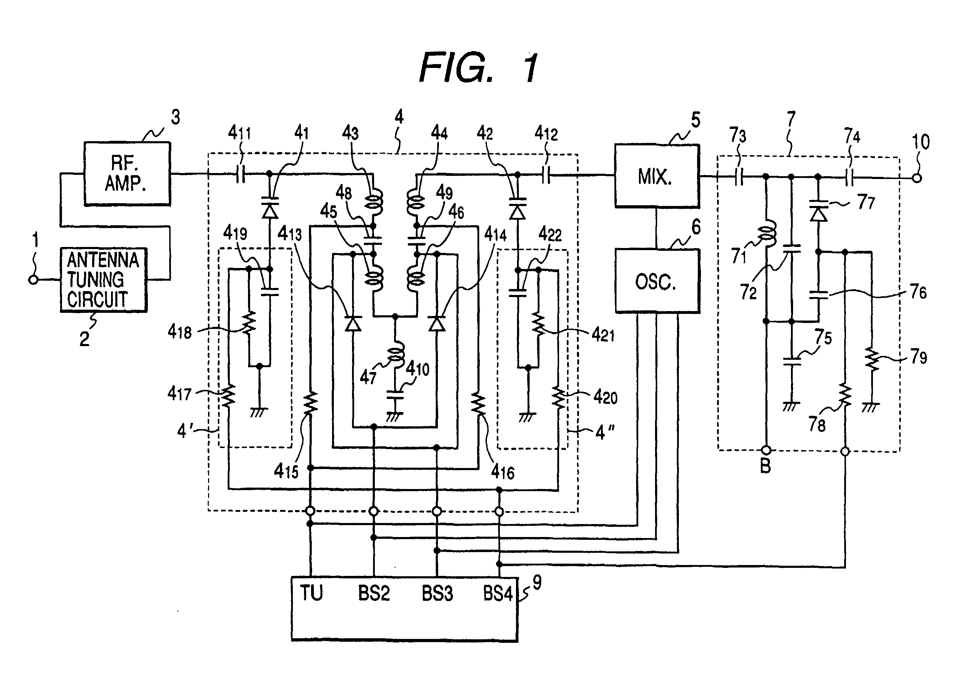

Fig. 1 is a block diagram partly including a circuit diagram, showing a configuration of a first embodiment of a television tuner according to the present invention.

As shown in Fig. 1, the television tuner according to the first embodiment is provided with an input terminal 1, an antenna (ANT) tuning circuit 2, a high-frequency amplifier circuit (RFAMP) 3, a high-frequency double tuned circuit 4, a mixer (MIX) 5, a local oscillator (OSC) 6, an intermediate frequency tuning circuit 7, a channel selecting IC 9, and an output terminal 10.

The high-frequency double tuned circuit 4 has an input terminal electrically connected to an output terminal of the high-frequency amplifier circuit 3 and an output terminal electrically connected to a first input terminal of the mixer 5. Further, the high-frequency double tuned circuit 4 comprises variable capacitance diodes 4₁ and 4₂, inductors 4₃ through 4₇, capacitors 4₈ through 4₁₂, switching diodes 4₁₃ and 4₁₄, resistors 4₁₅ and 4₁₆, and two resistive potential dividers 4' and 4". The variable capacitance diode 4₁ has a cathode electrically connected to one end of the inductor 4₃ and electrically connected to the input terminal of the high-frequency double tuned circuit 4 through the capacitor 4₁₁ and has an anode electrically connected to one resistive potential divider 4'. The variable capacitance diode 4₂ has a cathode electrically connected to one end of the inductor 4₄ and electrically connected to the output terminal of the high-frequency double tuned circuit 4 and has an anode electrically connected to the other resistive potential divider 4". The inductors 4₃ and 4₄ are electrically inductively-coupled to each other. The other end of the inductor 4₃ is electrically connected to one end of the inductor 4₅ through the capacitor 4₈ and electrically connected to a tuning voltage terminal TU of the IC 9 through the resistor 4₁₅. The other end of the inductor 4₄ is electrically connected to one end of the inductor 4₆ through the capacitor 4₉ and electrically connected to the tuning voltage terminal TU of the IC 9 through the resistor 4₁₆. The inductors 4₅ and 4₆ are electrically inductively-coupled to each other. The inductor 4₅ has one end electrically connected to a band switching terminal BS3 of the IC 9 and electrically connected to a band switching terminal BS2 through the switching diode 4₁₃ and has the other end electrically connected to the other end of the inductor 4₆ and one end of the inductor 4₇. The inductor 4₆ has one end electrically connected to the band switching terminal BS3 of the IC 9 and electrically connected to the band switching terminal BS2 through the switching diode 4₁₄. The inductor 4₇ has the other end electrically connected to the ground through the capacitor 4₁₀.

The resistive potential divider 4' comprises resistors 4₁₇ and 4₁₈ and a bypass capacitor 4₁₉. The resistor 4₁₇ has one end electrically connected to a band switching terminal BS4 of the IC 9 and the other end electrically connected to the anode of the variable capacitance diode 4₁, one end of the resistor 4₁₈ and one end of the bypass capacitor 4₁₉ respectively. The other end of the resistor 4₁₈ and the other end of the bypass capacitor 4₁₉ are respectively electrically connected to the ground. Further, the resistive potential divider 4" comprises resistors 4₂₀ and 4₂₁ and a bypass capacitor 4₂₂. The resistor 4₂₀ has one end electrically connected to the band switching terminal BS4 of the IC 9 and the other end electrically connected to the anode of the variable capacitance diode 4₂, one end of the resistor 4₂₁ and one end of the bypass capacitor 4₂₂ respectively. The other end of the resistor 4₂₁ and the other end of the bypass capacitor 4₂₂ are respectively electrically connected to the ground. Further, the local oscillator 6 has an output terminal electrically connected to a second input terminal of the mixer 5.

The intermediate frequency tuning circuit 7 has an input terminal electrically connected to an output terminal of the mixer 5 and an output terminal electrically connected to the output terminal 10. Further, the intermediate frequency tuning circuit 7 comprises an inductor 7₁, capacitors 7₂ through 7₆, a variable capacitance diode 7₇, and resistors 7₈ and 7₉. The inductor 7₁ has one end electrically connected to an input terminal of the intermediate frequency tuning circuit 7 through the capacitor 7₃ and electrically connected to the output terminal 10 through the capacitor 7₄. Further, the inductor 7₁ has the other end electrically connected to a power supply terminal B and electrically connected to the ground through the capacitor 7₅. The capacitor 7₂ is electrically connected in shunt with the inductor 7₁. The variable capacitance diode 7₇ has a cathode electrically connected to one end of the inductor 7₁ and an anode electrically connected to the other end of the inductor 7₁ through the capacitor 7₆. Further, the anode of the variable capacitance diode 7₇ is electrically connected to the band switching terminal BS4 of the IC 9 through the resistor 7₈ and electrically connected to the ground through the resistor 7₉.

The IC 9 is TSA5520 produced by Philips Corp. as an example. The IC 9 is provided with a band decoder in addition to a PLL circuit and has the tuning voltage terminal TU and the band switching terminals BS2, BS3 and BS4. Of these, the respective terminals excluding the band switching terminal BS4 are electrically connected to the high-frequency double tuned circuit 4 and the local oscillator 6, and the band switching terminal BS4 is electrically connected to the high-frequency double tuned circuit 4 and the intermediate frequency tuning circuit 7. Incidentally, the tuning voltage terminal TU outputs a tuning voltage therethrough, the band switching terminal BS2 outputs a positive voltage therethrough when a TV broadcast lying in a VHF high-band is selected, the band switching terminal BS3 outputs a positive voltage therethrough when a TV broadcast lying in a VHF low-band is selected, and the band switching terminal BS4 outputs a positive voltage therethrough when a TV broadcast of the SECAM (L) system lying in the VHF low-band is selected.

The television tuner of the first embodiment according to the above-described construction operates as follows:

A received signal applied to the input terminal 1 is inputted to the antenna tuning circuit 2 where a received signal corresponding to a desired channel is selected and thereafter amplified by the high-frequency amplifier circuit 3. The amplified received signal is inputted to the high-frequency double tuned circuit 4 where a received signal corresponding to a desired channel is further selected. The mixer 5 mixes the selected received signal and a local oscillation signal supplied from the local oscillator 6 so as to be converted into an intermediate frequency signal. The intermediate frequency signal is inputted to the intermediate frequency tuning circuit 7 where an intermediate frequency signal having a predetermined frequency is selected and outputted from the output terminal 10.

Thus, when a TV broadcast lying in a VHF low-band is selected, a positive voltage is outputted from the band switching terminal BS3 of the IC 9. Thus, the high-frequency double tuned circuit 4 takes such a configuration that in response to the positive voltage, the switching diodes 4₁₃ and 4₁₄ are respectively turned off and hence the inductors 4₅ through 4₇ and the capacitor 4₁₀ are inserted into and connected to the variable capacitance diodes 4₁ and 4₂, the inductors 4₃ and 4₄, and the capacitors 4₈ and 4₉.

On the other hand, when a TV broadcast lying in a VHF high-band is selected, a positive voltage is outputted from the band switching terminal BS2 of the IC 9. Thus, the high-frequency double tuned circuit 4 takes such a configuration that in response to the positive voltage, the switching diodes 4₁₃ and 4₁₄ are respectively turned on so that a circuit portion comprised of the inductors 4₅ through 4₇ and the capacitor 4₁₀ is short-circuited and hence only the variable capacitance diodes 4₁ and 4₂, the inductors 4₃ and 4₄ and the capacitors 4₈ and 4₉ are electrically connected to one another.

Even when the TV broadcast lying in any band is selected, a tuning voltage is outputted from the tuning voltage terminal TU of the IC 9 so that the high-frequency double tuned circuit 4 is activated as follows. That is, since the tuning voltage is applied to the variable capacitance diode 4₁ through the resistor 4₁₅ and the inductor 4₃ and further applied to the variable capacitance diode 4₂ through the resistor 4₁₆ and the inductor 4₄, the respective capacitance of the variable capacitance diodes 4₁ and 4₂ are adjusted so as to be tuned to the selected TV broadcast.

In a manner similar to the high-frequency double tuned circuit 4, the local oscillator 6 is supplied with the positive voltage outputted from the band switching terminal BS3 or BS2 of the IC 9 and the tuning voltage outputted from the tuning voltage terminal TU to thereby output a local oscillation signal having a frequency higher than that of the selected TV broadcast by a predetermined difference.

Further, in the television tuner according to the first embodiment, the respective tuning frequencies of the high-frequency double tuned circuit 4 and the intermediate frequency tuning circuit 7 are set so as to be adapted to a TV broadcast of the PAL (B/G) system. When a TV broadcast of the SECAM (L) system lying in the VHF low-band is selected, the television tuner shifts the respective tuning frequencies to low frequencies.

That is, when the television tuner according to the first embodiment selects the TV broadcast of the SECAM (L) system lying in the VHF low-band, the positive voltage is outputted from the band switching terminal BS4 of the IC 9 and applied to the high-frequency double tuned circuit 4 and the intermediate frequency tuning circuit 7.

The positive voltage is divided into fractions by the resistors 4₁₇, 4₁₈ and 4₂₀, 4₂₁ in the high-frequency double tuned circuit 4, which in turn are applied to the anodes of the variable capacitance diodes 4₁ and 4₂ as added bias voltages respectively. At this time, the tuning voltage outputted from the tuning voltage terminal TU of the IC 9 is applied to the cathodes of the variable capacitance diodes 4₁ and 4₂. Thus, the voltages corresponding to the differences between the tuning voltage and the added bias voltages are respectively applied between the anodes and cathodes of the variable capacitance diodes 4₁ and 4₂. Further, the respective capacitance of the variable capacitance diodes 4₁ and 4₂ become greater than those thereof at the time that only the tuning voltage is applied to the cathodes thereof.

Further, the positive voltage is adjusted so as to make a fractional voltage by the resistors 7₈ and 7₉ in the intermediate frequency tuning circuit 7, which in turn is applied to the anode of the variable capacitance diode 7₇ as an added bias voltage. At this time, a power supply voltage is applied to the cathode of the variable capacitance diode 7₇ from the power supply terminal B through the inductor 7₁ as a fixed bias voltage. Thus, the voltage corresponding to the difference between the fixed bias voltage and the added bias voltage is applied between the anode and cathode of the variable capacitance diode 7₇, and the capacitance of the variable capacitance diode 7₇ becomes greater than that thereof at the time that only the fixed bias voltage is applied to the cathode thereof. Accordingly, the respective tuning frequencies of the high-frequency double tuned circuit 4 and the intermediate frequency tuning circuit 7 are shifted to low frequencies as compared with when the added bias voltage is not applied to the cathode thereof.

On the other hand, when a TV broadcast of the SECAM (L) system and a TV broadcast of the PAL (B/G) system lying in a band other than the VHF low-band are selected, no positive voltage is outputted from the band switching terminal BS4 of the IC 9. Thus, only the tuning voltage is applied to the cathodes of the variable capacitance diodes 4₁ and 4₂ and the respective capacitances of the variable capacitance diodes 4₁ and 4₂ become smaller than those thereof at the time that the added bias voltages are applied to the cathodes thereof. Further, only the power supply voltage is applied to the cathode of the variable capacitance diode 7₇ and the capacitance of the variable capacitance diode 7₇ becomes smaller than that thereof at the time that the added bias voltage is applied to the cathode thereof. Thus, the respective tuning frequencies of the high-frequency double tuned circuit 4 and the intermediate frequency tuning circuit 7 are shifted to high frequencies as compared with the application of the added bias voltage to the cathode thereof.

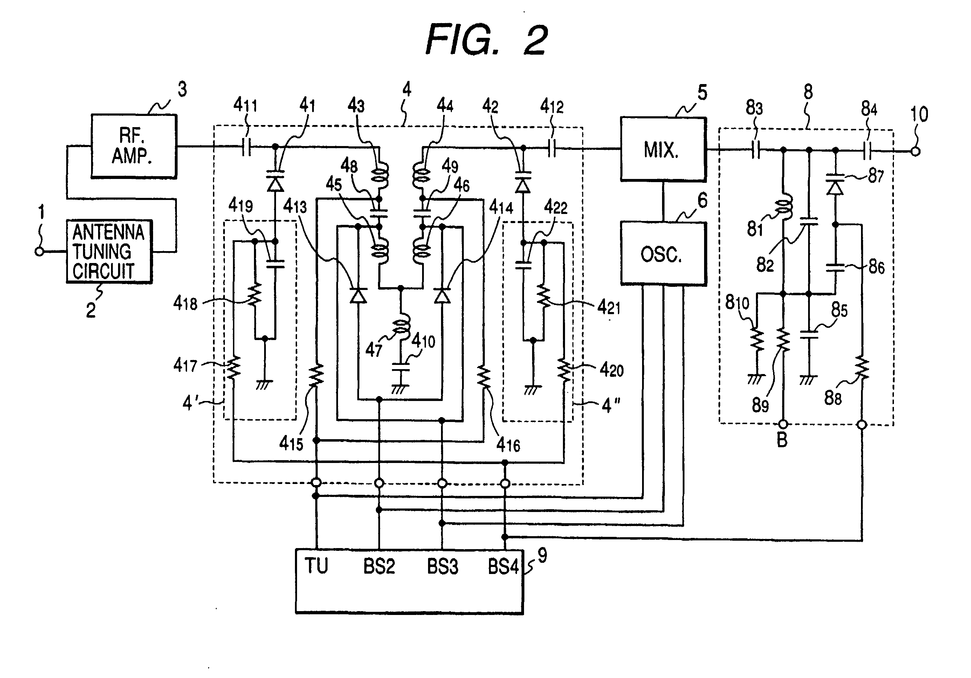

Next, Fig. 2 is a block diagram partly including a circuit diagram, showing a configuration of a second embodiment of a television tuner according to the present invention.

The television tuner according to the second embodiment is provided with an intermediate frequency tuning circuit 8 as an alternative to the intermediate frequency tuning circuit 7 employed in the television tuner according to the first embodiment shown in Fig. 1. Since the second embodiment is identical to the first embodiment in configurations and operations other than the intermediate frequency tuning circuit 8, the same elements of structure as those in Fig. 1 are identified by the same reference numerals in Fig. 2. Only the configuration and operation of the intermediate frequency tuning circuit 8 will be explained below. Other configurations and operations will not be described.

The intermediate frequency tuning circuit 8 has an input terminal electrically connected to an output terminal of a mixer 5 and an output terminal electrically connected to an output terminal 10. The intermediate frequency tuning circuit 8 comprises an inductor 8₁, capacitors 8₂ through 8₆, a switching diode 8₇, and resistors 8₈ through 8₁₀. The inductor 8₁ has one end electrically connected to the input terminal of the intermediate frequency tuning circuit 8 through the capacitor 8₃ and electrically connected to the output terminal thereof through the capacitor 8₄. Further, the inductor 8₁ has the other end electrically connected to a power supply terminal B through the resistor 8₉ and electrically connected to the ground through the parallel-connected resistor 8₁₀ and capacitor 8₅. The capacitor 8₂ is electrically connected in shunt with the inductor 8₁. The capacitor 8₆ has one end electrically connected to the anode of the switching diode 8₇ and the other end electrically connected to the other end of the inductor 8₁. Further, the switching diode 8₇ has a cathode electrically connected to one end of the inductor 8₁ and an anode electrically connected to a band switching terminal BS4 of an IC 9 through the resistor 8₈.

When a TV broadcast of the SECAM (L) system lying in a VHF low-band is now selected, a positive voltage is outputted from the band switching terminal BS4 of the IC 9 and applied to the anode of the switching diode 8₇ through the resistor 8₈ of the intermediate frequency tuning circuit 8 as a switching voltage. At this time, a power supply voltage applied to the power supply terminal B is adjusted so as to make a fractional voltage by the resistors 8₉ and 8₁₀, which in turn is applied to the cathode of the switching diode 8₇ through the inductor 8₁ as a fixed bias voltage. Since, however, the switching voltage is higher than the fixed bias voltage, the switching diode 8₇ is brought to an on state. Further, the capacitor 8₆ is electrically parallel-connected to the capacitor 8₂ and the tuning capacitance of the intermediate frequency tuning circuit 8 becomes greater than that thereof at the time that the switching voltage is not applied to the cathode referred to above. Thus, the tuning frequency of the intermediate frequency tuning circuit 8 is shifted to a low frequency as compared with the non-application of the switching voltage thereto.

On the other hand, when a TV broadcast of the SECAM (L) system and a TV broadcast of the PAL (B/G) system lying in a band other than the VHF low-band are selected, no positive voltage is outputted from the band switching terminal BS4 of the IC 9, so that the switching diode 8₇ is brought to an off state, whereby the tuning capacitance of the intermediate frequency tuning circuit 8 becomes smaller than that thereof at the application of the switching voltage. Thus, the tuning frequency of the intermediate frequency tuning circuit 8 is shifted to a high frequency as compared with the application of the switching voltage.

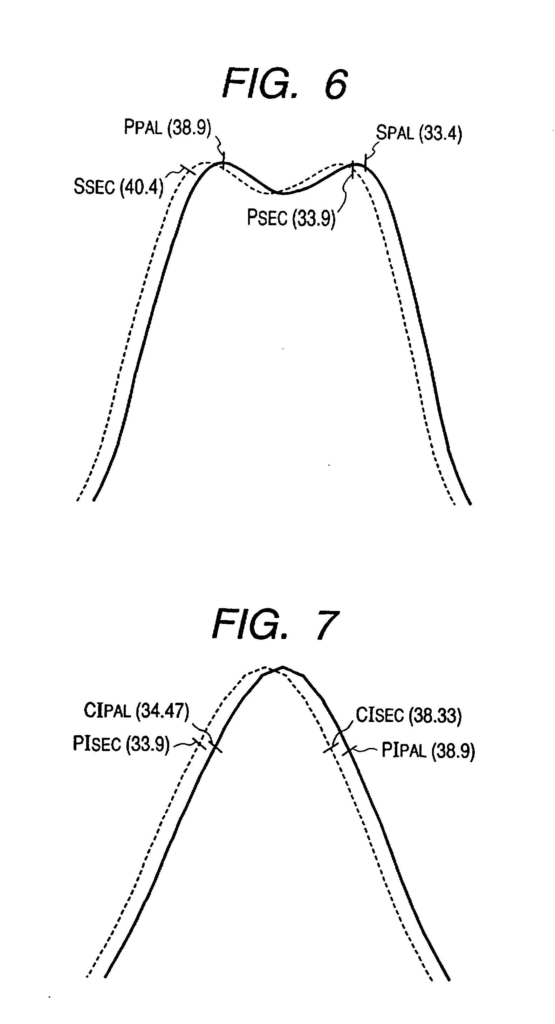

Fig. 6 shows tuning characteristics of the high-frequency double tuned circuit 4 in the television tuner according to each embodiment at the time that the TV broadcast lying in the VHF low-band is selected. In Fig. 6, a solid line indicates a characteristic obtained when the TV broadcast of the PAL (B/G) system is selected, whereas a broken line indicates a characteristic obtained when the TV broadcast of the SECAM (L) system is selected. Symbols P_{PAL} and S_{PAL} in the drawing indicate a video or picture carrier and a voice or speech carrier of the TV broadcast of the PAL (B/G) system respectively, whereas symbols P_{SEC} and S_{SEC} indicate a picture carrier and a speech carrier of the TV broadcast of the SECAM (L) system respectively. However, numeric values in the drawing are those represented by replacing the frequencies of the respective carriers with intermediate frequencies for convenience. The relationship in magnitude between the frequencies of the respective carriers is contrary to an arrangement of the numeric values in the drawing, i.e., they are small on the left side in the drawing, whereas they are large on the right side in the drawing.

As shown in Fig. 6, the tuning characteristic of the high-frequency double tuned circuit 4 remains unchanged upon selection of the TV broadcast of the PAL (B/G) system as compared with the tuning characteristic of the high-frequency double tuned circuit 64 employed in the already-known television tuner shown in Fig. 4. When the TV broadcast of the SECAM (L) system is selected, the tuning characteristic thereof is shifted to the low frequency. Even when the TV broadcast of either system is selected, response ranges substantially coincide with each other and the picture carrier and speech carrier are substantially equal in response level to each other.

Fig. 7 shows tuning characteristics of the intermediate frequency tuning circuits 7 and 8 in the television tuner according to each embodiment at the time that the TV broadcast lying in the VHF low-band is selected. In Fig. 7, a solid line indicates a characteristic obtained when a TV broadcast of the PAL (B/G) system is selected, whereas a broken line indicates a characteristic obtained when a TV broadcast of the SECAM (L) system is selected. Symbols PI_{PAL} and CI_{PAL} in the drawing indicate a video or picture intermediate frequency and a chrominance intermediate frequency of the TV broadcast of the PAL (B/G) system, respectively, whereas symbols PI_{SEC} and CI_{SEC} indicate a video or picture intermediate frequency and a chrominance intermediate frequency of the TV broadcast of the SECAM (L) system, respectively.

As shown in Fig. 7, the tuning characteristics of the intermediate frequency tuning circuits 7 and 8 remain unchanged upon selection of the TV broadcast of the PAL (B/G) system as compared with the tuning characteristic of the intermediate frequency tuning circuit 67 employed in the already-known television tuner shown in Fig. 5. When the TV broadcast of the SECAM (L) system is selected, the tuning characteristics thereof are shifted to the low frequency. Even when the TV broadcast of either system is selected, the tuning frequencies are located substantially in the centers of the picture intermediate frequencies and chrominance intermediate frequencies respectively.

While the respective embodiments have been described by the example in which the added bias voltages are applied to the two variable capacitance diodes 4₁ and 42 of the high-frequency double tuned circuit 4, it is unnecessary to apply the added bias voltages employed in the present invention to both the variable capacitance diodes. When the less shift of the tuning frequency of the high-frequency double tuned circuit 4 is allowed, the added bias voltage may simply be applied to one variable capacitance diode.

While the respective embodiments have been described by the example in which the tuning voltage is applied to the cathodes of the respective variable capacitance diodes 4₁ and 4₂ and the added bias voltages are applied to the anodes thereof, the form of the supply of the tuning voltage and the added bias voltages employed in the present invention is not necessarily limited to this example. Both the tuning voltage and the added bias voltage are superimposed on each other and the superimposed voltage may be applied to the above-described cathodes.

While the positive voltage obtained from the band switching terminal BS4 of the IC 9 is used as the added bias voltage or the switching voltage in each embodiment, the added bias voltage or switching voltage employed in the present invention is not limited to this positive voltage. Another voltage may be used if the voltage obtained only when the TV broadcast of the SECAM (L) system lying in the VHF low-band is selected, is taken.

According to the television tuner of each embodiment, as has been described above, the tuning frequencies of the high-frequency double tuned circuit and the intermediate frequency tuning circuit are set *so* as to be adapted to the TV broadcast of the PAL (B/G) system. When the TV broadcast of the SECAM (L) system lying in the VHF low-band is selected, the respective tuning capacitance of the high-frequency double tuned circuit and the intermediate frequency tuning circuit are made great. That is, when the TV broadcast of the SECAM (L) system lying in the VHF low-band is received, the tuning frequencies of the high-frequency double tuned circuit and the intermediate frequency tuning circuit, which have been set so as to be adopted to the TV broadcast of the PAL (B/G) system, are shifted to the low frequency and thereby adapted to the TV broadcast of the SECAM (L) system lying in the VHF low-band.

Thus, according to the television tuner of the present invention, an effect can be obtained in that even if the TV broadcast of either system is selected, both selectivity to the picture carrier and speech carrier of the high-frequency double tuned circuit is substantially equal to each other, and both selectivity to the picture intermediate frequency and chrominance intermediate frequency of the intermediate frequency tuning circuit is substantially equal to each other, whereby the picture and voices can be reproduced in a satisfactory state.

While the present invention has been described with reference to the illustrative embodiments, this description is not intended to be construed in a limiting sense. Various modifications of the illustrative embodiments, as well as other embodiments of the invention, will be apparent to those skilled in the art on reference to this description. It is therefore contemplated that the appended claims will cover any such modifications or embodiments as fall within the true scope of the invention which is, however, still defined by the appended claims.

## Claims

1. A television tuner, comprising:
a high-frequency double tuned circuit (4);
an intermediate frequency tuning circuit (7,8); and
means capable of receiving respective television broadcasts of PAL-B/G and SECAM-L-systems, said means setting respective tuning frequencies of said high-frequency double tuned circuit and said intermediate frequency tuning circuit so as to be adapted to the television broadcast of the PAL-B/G-system **characterized in that** said means is further adapted for lowering the respective tuning frequencies of said high-frequency double tuned circuit and said intermediate frequency tuning circuit when the television broadcast of the SECAM-L-system lying in a VHF low-band is received.

2. The television tuner according to claim 1,
wherein said high-frequency double tuned circuit and said intermediate frequency tuning circuit (7) are respectively provided with variable capacitance diodes (4₁,4₂,7₇), and when the television broadcast of the SECAM-L-system lying in the VHF low-band is received, an added bias voltage for increasing the capacitance of the variable capacitance diodes (4₁,4₂) of said high-frequency double tuned circuit as compared with the application of only a tuning voltage is applied to the variable capacitance diodes thereof together with the tuning voltage and an added bias voltage for increasing the capacitance of the variable capacitance diode (7₇) of said intermediate frequency tuning circuit as compared with the application of only a fixed bias voltage is applied to the variable capacitance diode thereof together with the fixed bias voltage, and when another television broadcast is received, only said tuning voltage is applied to the variable capacitance diodes of said high-frequency double tuned circuit and only said fixed bias voltage is applied to the variable capacitance diode of said intermediate frequency tuning circuit.

3. The television tuner according to claim 2,
wherein said added bias voltages are fractional voltages obtained by dividing a band switching voltage outputted from a channel selecting IC (9) provided with a band decoder by resistance circuits (4',4") and said fixed bias voltage is a voltage higher than said each added bias voltage, and the tuning voltage is applied to the cathodes of the variable capacitance diodes of said high-frequency double tuned circuit and said added bias voltage is applied to the anodes thereof, whereas the fixed bias voltage is applied to the cathode of the variable capacitance diode of said intermediate frequency tuning circuit and the added bias voltage is applied to the anode thereof.

4. The television tuner according to claim 1,
wherein said high-frequency double tuned circuit is provided with variable capacitance diodes (4₁, 4₂) and said intermediate frequency tuning circuit (8) is provided with a fixed capacitor (8₂) and an added capacitor (8₆) series-connected to a switching diode (8₇), and when a television broadcast of the SECAM-L-system lying in a VHF low-band is received, an added bias voltage for increasing the capacitance of the variable capacitance diodes of said high-frequency double tuned circuit as compared with the application of only a tuning voltage is applied to the variable capacitance diodes thereof together with the tuning voltage, and a switching voltage for bringing the switching diode to an on state is applied to said switching diode so as to turn on said switching diode, thereby connecting said added capacitor in parallel with said fixed capacitor, and when another television broadcast is received, only the tuning voltage is applied to said variable capacitance diodes and a switching voltage for bringing the switching diode to an off state is applied to said switching diode so as to turn off said switching diode, thereby disconnecting said added capacitor from said fixed capacitor.

5. The television tuner according to claim 4, wherein said added bias voltage is a fractional voltage obtained by dividing a band switching voltage outputted from a channel selecting IC (9) provided with a band decoder by a resistance circuit and said switching voltage is said band switching voltage, and said tuning voltage is applied to the cathodes of said variable capacitance diodes and said added bias voltage is applied to the anodes thereof, whereas a fixed bias voltage lower than said band switching voltage is applied to the cathode of said switching diode and said band switching voltage is applied to the anode thereof.

## Patentansprüche

1. Fernsehtuner bestehend aus:
einem doppelt abgestimmten Hochfrequenzkreis (4);
einem Zwischenfrequenz- Abstimmkreis (7, 8);
und einem Mittel zum Empfang von Fernsehsignalen entsprechend den Systemen PAL - B/G und SECAM - L, wobei dieses Mittel die Abstimmfrequenzen des besagten doppelt abgestimmten Hochfrequenzkreises und des besagten Zwischenfrequenz-Abstimmkreises so einstellt, dass sie dem PAL - B/G - Fernsehsystem entsprechen, **dadurch gekennzeichnet, dass** das besagte Mittel weiter eingerichtet ist, die entsprechenden Abstimmfrequenzen des besagten doppelt abgestimmten Hochfrequenzkreises und des besagten Zwischenfrequenz- Abstimmkreises zu erniedrigen, wenn ein SECAM - L - Fernsehsignal in einem niedrigen VHF - Band empfangen wird.

2. Fernsehtuner nach Anspruch 1, wobei der besagte doppelt abgestimmte Hochfrequenzkreis und
der besagte Zwischenfrequenz- Abstimmkreis jeweils mit Kapazitätsdioden (41, 42, 77) ausgestattet sind und wenn ein Fernsehsignal des SECAM - L - Systems in einem niedrigen VHF - Band empfangen wird, eine zusätzliche Vorspannung zur Erhöhung der Kapazität der Kapazitätsdioden (41, 42) des besagten doppelt abgestimmten Hochfrequenzkreises im Vergleich zum Anlegen nur einer Abstimmspannung an deren Kapazitätsdioden zusammen mit der Abstimmspannung angelegt wird und eine zusätzliche Vorspannung zur Erhöhung der Kapazität der Kapazitätsdiode (77) des besagten Zwischenfrequenz- Abstimmkreises im Vergleich zum Anlegen nur einer festen Vorspannung an dessen Kapazitätsdiode zusammen mit der festen Vorspannung angelegt wird, und wenn ein anderes Fernsehsignal empfangen wird, nur die besagte Abstimmspannung an die Kapazitätsdioden des besagten doppelt abgestimmten Hochfrequenzkreises und nur die feste Vorspannung an die Kapazitätsdiode des besagten Zwischenfrequenz- Abstimmkreises angelegt wird.

3. Fernsehtuner nach Anspruch 2, wobei die besagten zusätzlichen Vorspannungen Teilspannungen sind, die durch Spannungsteilung mit Widerstandsschaltungen (4', 4") aus einer Bandumschaltspannung gewonnen werden, die von einem Kanalwähler - IC (9) mit Banddecoder abgegeben wird und wobei die besagte feste Vorspannung eine Spannung ist, die höher ist als jede der besagten zusätzlichen Vorspannungen und wobei die Abstimmspannung an die Kathoden der Kapazitätsdioden des besagten doppelt abgestimmten Hochfrequenzkreises und die besagte zusätzliche Vorspannung an deren Anoden gelegt wird, während die feste Vorspannung an die Kathode der Kapazitätsdiode des besagten Zwischenfrequenz- Abstimmkreises und die zusätzliche Vorspannung an deren Anode gelegt wird.

4. Fernsehtuner nach Anspruch 1, wobei der besagte doppelt abgestimmte Hochfrequenzkreis mit Kapazitätsdioden (41, 42) ausgestattet ist und der besagte Zwischenfrequenz- Abstimmkreis (8) mit einem Festkondensator (82) und einem zusätzlichen Kondensator (86) in Serie mit einer Schaltdiode (87) ausgestattet ist und wenn ein Fernsehsignal des SECAM - L - Systems in einem niedrigen VHF - Band empfangen wird, eine zusätzliche Vorspannung zur Erhöhung der Kapazität der Kapazitätsdioden des besagten doppelt abgestimmten Hochfrequenzkreises im Vergleich zum Anlegen nur einer Abstimmspannung an deren Kapazitätsdioden zusammen mit der Abstimmspannung angelegt wird, und eine Schaltspannung wird an die Schaltdiode gelegt, um die Schaltdiode in einen Einschaltzustand zu bringen, wobei durch das Einschalten der Schaltdiode der besagte zusätzliche Kondensator parallel zu dem besagten Festkondensator angeschlossen wird, und wenn ein anderes Fernsehsignal empfangen wird, nur die besagte Abstimmspannung an die Kapazitätsdioden gelegt wird und eine Schaltspannung wird an die Schaltdiode gelegt, um die Schaltdiode in einen Ausschaltzustand zu bringen, wobei durch das Ausschalten der Schaltdiode der besagte zusätzliche Kondensator von dem besagten Festkondensator getrennt wird.

5. Femsehtuner nach Anspruch 4, wobei die besagte zusätzliche Vorspannung eine Teilspannung ist, die durch Spannungsteilung mit einer Widerstandsschaltung aus einer Bandumschaltspannung gewonnen wird, die von einem Kanalwähler - IC (9) mit Banddecoder abgegeben wird und wobei die besagte Schaltspannung die besagte Bandumschaltspannung ist und wobei die Abstimmspannung an die Kathoden der besagten Kapazitätsdioden und die besagte zusätzliche Vorspannung an deren Anoden gelegt wird, während eine feste Vorspannung, die niedriger ist als die besagte Bandumschaltspannung, an die Kathode der besagten Schaltdiode und die besagte Bandumschaltspannung an deren Anode gelegt wird.

## Revendications

1. Un dispositif d'accord de télévision, comprenant:
un circuit double accordé (4) à haute fréquence;
un circuit d'accord (7, 8) de fréquence intermédiaire; et
un moyen pouvant recevoir des émissions de télévision respectives en systèmes PAL et SECAM,, ce moyen réglant des fréquences d'accord respectives du circuit haute fréquence double accordé et du circuit d'accord de fréquence intermédiaire de façon à ce que cela soit adapté à l'émission de télévision en système PAL, **caractérisé en ce que** ce moyen est aussi adapté pour baisser les fréquences d'accord respectives du circuit double accordé de haute fréquence et du circuit d'accord de fréquence intermédiaire quand l'émission télévisée en système SECAM se trouvant dans une low-band VHF est reçue.

2. Un dispositif d'accord de télévision selon la revendication 1, dans lequel ce circuit de haute fréquence double accordé et ce circuit d'accord de fréquence intermédiaire (7) sont respectivement pourvus de diodes de capacité variable (4₁,4₂,7₇), et quand l'émission de télévision en système SECAM se trouvant dans la bande low-band VHF est reçue, une tension de polarisation ajoutée pour accroître la capacité des diodes (4₁,4₂) de ce circuit accordé double de haute fréquence, par rapport à l'application d'une tension d'accord seule, est appliquée à ses diodes de capacité variable en même temps que la tension d'accord et une tension de polarisation ajoutée pour accroître la capacité de la diode (7₇) de capacité variable de ce circuit d'accord de fréquence intermédiaire, par rapport à l'application d'un tension de polarisation fixe seule, est appliquée à la diode de capacité variable en même temps que la tension de polarisation fixe, et quand une autre émission de télévision est reçue, cette tension d'accord seule est appliquée aux diodes de capacité variable du circuit de haute fréquence accordé double et la tension fixe de polarisation seule est appliquée à la diode de capacité variable de ce circuit d'accord de fréquence intermédiaire.

3. Un dispositif d'accord de télévision selon la revendication 2, dans lequel ces tensions de polarisation ajoutées sont des tensions fractionnaires obtenues en divisant une tension de commutation de bande sortie d'un CI (9) sélecteur de canal, pourvu d'un décodeur de bande par des circuits de résistance (4', 4") et la tension de polarisation est une tension plus élevée que la tension de polarisation ajoutée, et la tension d'accord est appliquée aux cathodes des diodes de capacité variable du circuit d'accord de fréquence double et cette tension de polarisation ajoutée est appliquée à ses anodes, alors que la tension de polarisation fixe est appliquée à la cathode de la diode de capacité variable de ce circuit d'accord de fréquence intermédiaire et la tension de polarisation ajoutée est appliquée à son anode.

4. Le dispositif d'accord de télévision selon la revendication 1, dans lequel ce circuit d'accord double à haute fréquence est pourvu de diodes (4₁,4₂) à capacité variable et le circuit d'accord de fréquence intermédiaire (8) est pourvu d'un condensateur fixe (8₂) et un condensateur ajouté (8₆), connecté sériellement à une diode de commutation (8₇), et quand une émission de télévision du système SECAM se trouvant dans une low-band VHF est reçue, une tension de polarisation ajoutée pour accroître la capacité des diodes de capacité variable de ce circuit double accordé à haute fréquence, par rapport à l'application d'une tension d'accord seule, est appliquée aux diodes de capacité variable en même temps que la tension d'accord, et une tension de commutation pour faire arriver la diode de commutation à l'état de marche est appliquée à cette diode de commutation de façon à mettre en marche cette diode de commutation, connectant par ce fait le condensateur ajouté en parallèle avec le condensateur fixe, et quand une autre émission de télévision est reçue, seule la tension d'accord est appliquée à ces diodes de capacitance variable et une tension de commutation pour débrancher la diode de commutation est appliquée à la diode de commutation de façon à la mettre hors circuit, coupant ainsi le condensateur ajouté du condensateur fixe.

5. Le dispositif d'accord de télévision selon la revendication 4, dans lequel la tension de polarisation ajoutée est une tension fractionnaire obtenue en divisant une tension de commutation de bande sortie d'un CI (9) sélecteur de canal pourvu d'un décodeur de bande par un circuit de résistance et cette tension de commutation est la tension de commutation de bande, et la tension d'accord est appliquée aux cathodes des diodes de capacité variable et cette tension de polarisation ajoutée est appliquée à ses anodes, alors qu'une tension de polarisation fixe plus basse que la tension de commutation de bande est appliquée à la cathode de commutation et cette tension de commutation de bande est appliquée à son anode.
